# EUROPEAN PATENT SPECIFICATION

(11) **EP 3 295 679 B1**
(45) Date of publication and mention of the grant of the patent: **16.01.2019**
(21) Application number: 15727429.1
(22) Date of filing: 12.05.2015
(51) Int. Cl.: H04Q 1/02

(54) **TELECOMMUNICATION EQUIPMENT**
TELEKOMMUNIKATIONSEINRICHTUNG
ÉQUIPEMENT DE TÉLÉCOMMUNICATION

(43) Date of publication of application: 21.03.2018
(73) Proprietor: Coriant Oy, 02630 Espoo (FI)
(72) Inventor: HOLMA, Antti, FI-02920 Espoo (FI); KOHONEN, Petri, FI-01650 Vantaa (FI)
(74) Representative: Finnpatent Oy
(86) International application number: PCT/FI2015/050318
(87) International publication number: WO 2016/181018

(56) References cited:
- US-A- 5 823 804
- US-B1- 7 817 398

## Description

### Field of the disclosure

The disclosure relates to telecommunication equipment comprising one or more telecommunication devices and a rack for mechanically supporting the telecommunication devices.

### Background

In many cases it is advantageous that telecommunication equipment is modular so that the telecommunication equipment comprises a rack and one or more changeable telecommunication devices that are installed in the rack. In this document the term "telecommunication" includes also "data communication" and other data and message transfer technologies. Each telecommunication device can be, for example but not necessarily, an internet protocol "IP" router, an Ethernet switch, an Asynchronous Transfer Mode "ATM" switch, a MultiProtocol Label Switching "MPLS" switch, and/or a packet optical switch.

The rack of modular telecommunication equipment comprises typically rails that are substantially vertical when the rack is in its operating position. A telecommunication device may comprise a device-frame and one or more plug-in units installed in plug-in unit slots of the device-frame. The device-frame is attachable to the vertical rails of the rack with e.g. one or more mounting screws. The device-frame may comprise a back-plane that comprises electrical connectors for connecting to the plug-in units and wirings for communicatively interconnecting the plug-in units. In principle, it is also possible to use separate cablings for arranging the connections between the plug-in units but in practice the approach based on the back-plane comprising the electrical connectors and the wirings is usually more advantageous. It is also possible that a telecommunication device is a single unit that is attachable to the vertical rails of the rack. Telecommunication devices which are often called "pizza-box" devices are examples of telecommunication devices each being a single unit attachable to the vertical rails of the rack.

The rack is typically provided with one or more grounding connectors which enable a maintenance person to ground himself to the rack during maintenance work. The grounding is needed in order to prevent static electricity from damaging the electronic components of the one or more telecommunication devices during the maintenance work. Each grounding connector can be for example a popper element mounted on the rack with a screw. The maintenance person has a grounding cable having one end provided with a counterpart of the above-mentioned popper element and another end connected for example to the clothes of the maintenance person.

An inherent inconvenience related to a grounding arrangement of the kind described above is that the telecommunication devices carried by the rack may have different physical dimensions. Thus, a grounding connector and its mounting screw which are located so that they do not disturb the positioning of telecommunication devices having certain physical dimensions may, however, severely limit the positioning of telecommunication devices having other physical dimensions.

Publication US7817398 describes a surge-protection system that comprises plurality of surge-arrestor modules for regulating surges between telecommunication devices, and a mounting-frame assembly suitable for mounting the surge-arrestor modules on a wall. Each surge-arrestor module is attached to the mounting-frame assembly with a mounting screw.

### Summary

The following presents a simplified summary in order to provide basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the invention, there is provided new telecommunication equipment that may comprise, for example but not necessarily, an Internet Protocol "IP" router, an Ethernet switch, a MultiProtocol Label Switching "MPLS" switch, an Asynchronous Transfer Mode "ATM" switch, and/or a packet optical switch.

Telecommunication equipment according to the invention comprises:
- a rack for carrying telecommunication devices, and
- at least one telecommunication device attached to the rack with one or more mounting screws.

The head of at least one of the mounting screws is shaped to constitute a grounding connector for a connector terminal of a grounding cable so that the connector terminal is connectable to the grounding connector without loosening, detaching, or otherwise changing the position of the mounting screw with respect to the rack and to the telecommunication device attached to the rack with at least the mounting screw under consideration. For example, the head of the mounting screw can be shaped to be a male popper element having a recess suitable for a screwdriver.

There is no need for a separate grounding connector and its mounting screw because the at least one mounting screw of the telecommunication device is arranged to act not only as the mounting screw of the telecommunication device but also as the grounding connector. Thus, the grounding connector does not limit the positioning of the telecommunication devices to be installed in the rack.

A number of exemplifying and non-limiting embodiments of the invention are described in accompanied dependent claims.

Various exemplifying and non-limiting embodiments of the invention both as to constructions and to methods of operation, together with additional objects and advantages thereof, will be best understood from the following description of specific exemplifying embodiments when read in connection with the accompanying drawings.

The verbs "to comprise" and "to include" are used in this document as open limitations that neither exclude nor require the existence of unrecited features. The features recited in dependent claims are mutually freely combinable unless otherwise explicitly stated. Furthermore, it is to be understood that the use of "a" or "an", i.e. a singular form, throughout this document does not exclude a plurality.

### Brief description of figures

Exemplifying and non-limiting embodiments of the invention and their advantages are explained in greater detail below in the sense of examples and with reference to the accompanying drawings, in which:
figure 1a illustrates telecommunication equipment according to an exemplifying and non-limiting embodiment of the invention,
figure 1b shows details of the telecommunication equipment illustrated in figure 1a,
figure 2 shows details of telecommunication equipment according to an exemplifying and non-limiting embodiment of the invention,
figure 3 shows details of telecommunication equipment according to an exemplifying and non-limiting embodiment of the invention, and
figure 4 shows details of telecommunication equipment according to an exemplifying and non-limiting embodiment of the invention.

### Description of exemplifying and non-limiting embodiments

The specific examples provided in the description given below should not be construed as limiting the scope and/or the applicability of the appended claims. Lists and groups of examples provided in the description given below are not exhaustive unless otherwise explicitly stated.

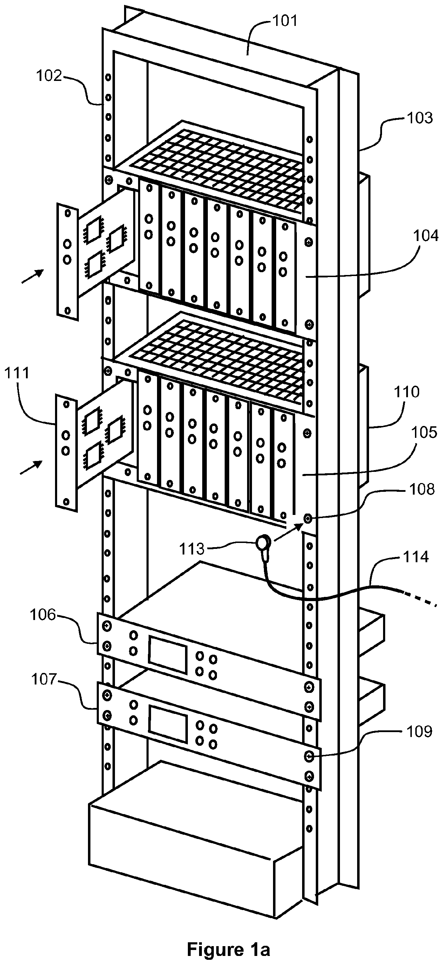

Figure 1a illustrates telecommunication equipment according to an exemplifying and non-limiting embodiment of the invention. The equipment comprises a rack 101 and telecommunication devices 104, 105, 106 and 107 installed in the rack. Each telecommunication device may comprise, for example but not necessarily, an internet protocol "IP" router, an Ethernet switch, an Asynchronous Transfer Mode "ATM" switch, a MultiProtocol Label Switching "MPLS" switch and/or a packet optical switch. The rack 101 comprises mutually parallel rails 102 and 103 that are substantially vertical when the rack is in its operating position. In this exemplifying case, the telecommunication devices 104 and 105 are modular so that each of these telecommunication devices 104 and 105 comprises a device-frame and plug-in units installed in plug-in unit slots of the device-frame. The device-frame is attachable to the vertical rails 102 and 103 of the rack with mounting screws. The device-frame may comprise a back-plane that comprises electrical connectors for connecting to the plug-in units and wirings for communicatively interconnecting the plug-in units. In principle, it is also possible to use separate cablings for arranging the connections between the plug-in units but in practice the approach based on the back-plane of the kind mentioned above is usually more advantageous. In figure 1a, the device-frame of the telecommunication device 105 is denoted with a reference number 110 and one of the plug-in units of the telecommunication device 105 is denoted with a reference number 111. One of the mounting screws of the telecommunication device 105 is denoted with a reference number 108. The telecommunication devices 106 and 107 are non-modular and they are attached to the vertical rails 102 and 103 of the rack 101 as illustrated in figure 1a. Typically, telecommunication devices such as the telecommunication devices 108 and 109 are called "pizza-box" devices. In figure 1a, one of the mounting screws of the telecommunication device 107 is denoted with a reference number 109. Telecommunication equipment of the kind illustrated in figure 1a is often enclosed with a cabinet and the telecommunication equipment is often provided with one or more cooling fans for blowing cooling air. Neither the cabinet nor the cooling fans are shown in figure 1a.

The head of at least one of the above-mentioned mounting screws is shaped to constitute a grounding connector for a connector terminal 113 of a grounding cable 114 so that the connector terminal 113 can be connected to the grounding connector without loosening, detaching, or otherwise changing the position of the mounting screw with respect to the rack 101 and to the telecommunication device attached to the rack with at least the mounting screw under consideration. The other end of the grounding cable 114 is connectable for example to clothes of a maintenance person so as to prevent static electricity from damaging the electronic components of the telecommunication devices 104-107 during maintenance work. The other end of the grounding cable 114 is not shown in figure 1a.

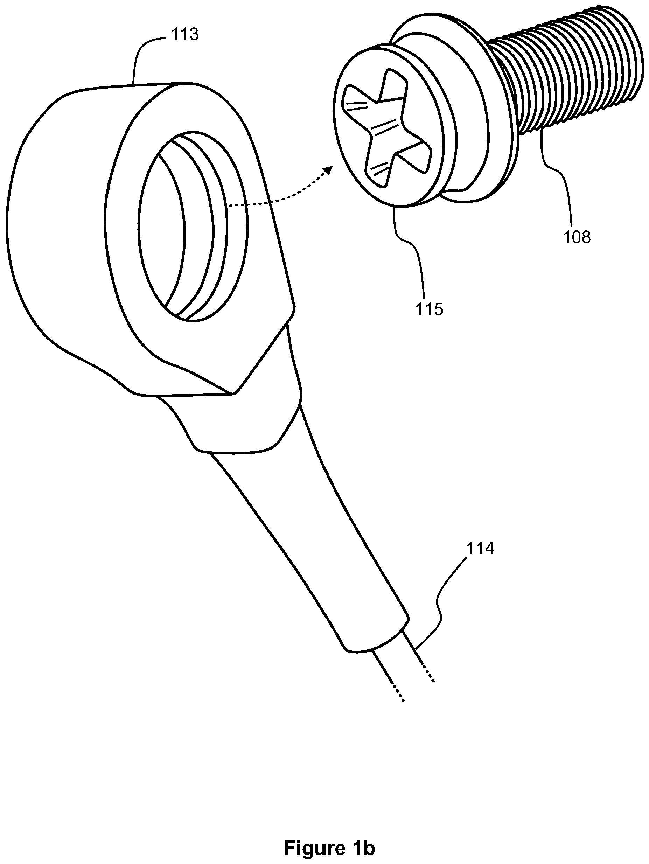

In the exemplifying telecommunication equipment illustrated in figure 1a, the head of at least the mounting screw 108 is shaped to constitute a grounding connector of the kind mentioned above. The heads of one or more of the other mounting screws can as well be shaped to constitute grounding connectors for coupling to the connector terminal 113 of the grounding cable 114. Figure 1b shows magnified views of the mounting screw 108 and the connector terminal 113. In this exemplifying case, the head 115 of the mounting screw 108 is shaped to be a male popper element having a recess suitable for a screwdriver. In this exemplifying case, the recess is suitable for a crosshead screwdriver, i.e. for a phillips screwdriver. The recess of the head 115 could as well be designed for a flat-, hexagonal, or torxhead screwdriver. The connector terminal 113 of the grounding cable 114 comprises a female popper element suitable for the male popper element constituted by the head 115 of the mounting screw 108.

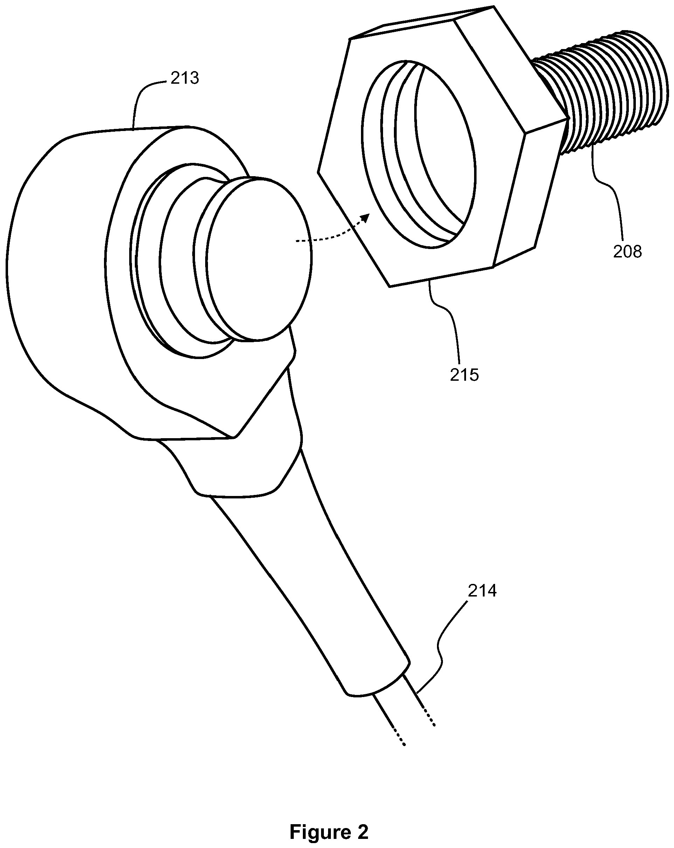

Figure 2 shows a mounting screw 208 and a connector terminal 213 according to another exemplifying and non-limiting embodiment of the invention. In this exemplifying case, the head 215 of the mounting screw 208 is a female popper element having an angulate outer periphery suitable for being twisted with a wrench. In this exemplifying case, the angulate outer periphery of the head 215 is hexagonal. The connector terminal 213 of the grounding cable 214 comprises a male popper element suitable for the female popper element constituted by the head 215 of the mounting screw 208.

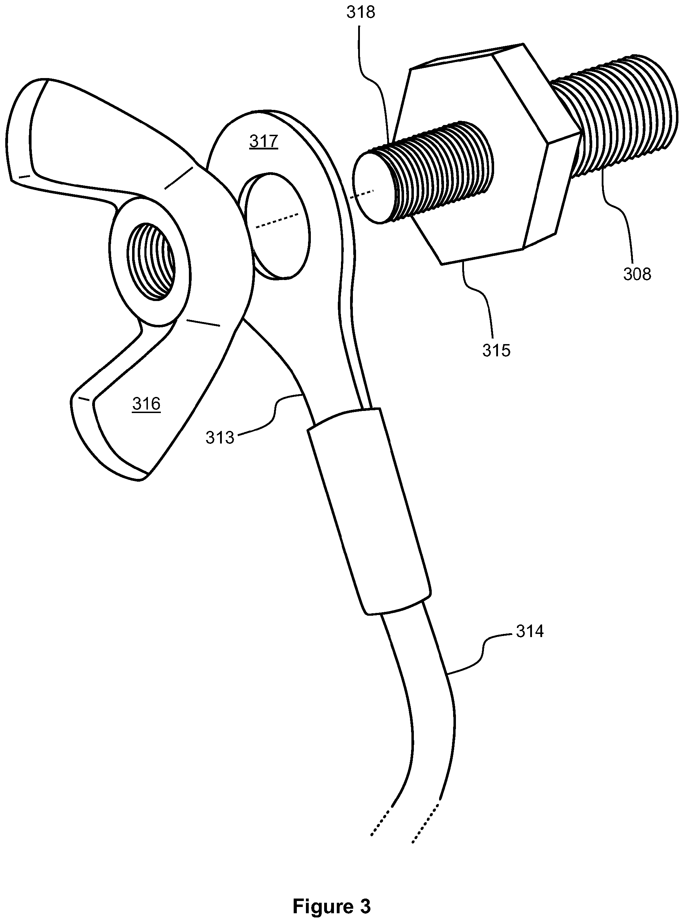

Figure 3 shows a mounting screw 308 and a connector terminal 313 according to an exemplifying and non-limiting embodiment of the invention. In this exemplifying case, the head 315 of the mounting screw comprises a threaded rod 318. The connector terminal 313 of the grounding cable 314 comprises a connector 317 that is attachable to the mounting screw 308 with a nut 316 suitable for the threaded rod 318. In the exemplifying case illustrated in figure 3, the nut 316 is a winged nut and the connector 317 is a loop connector.

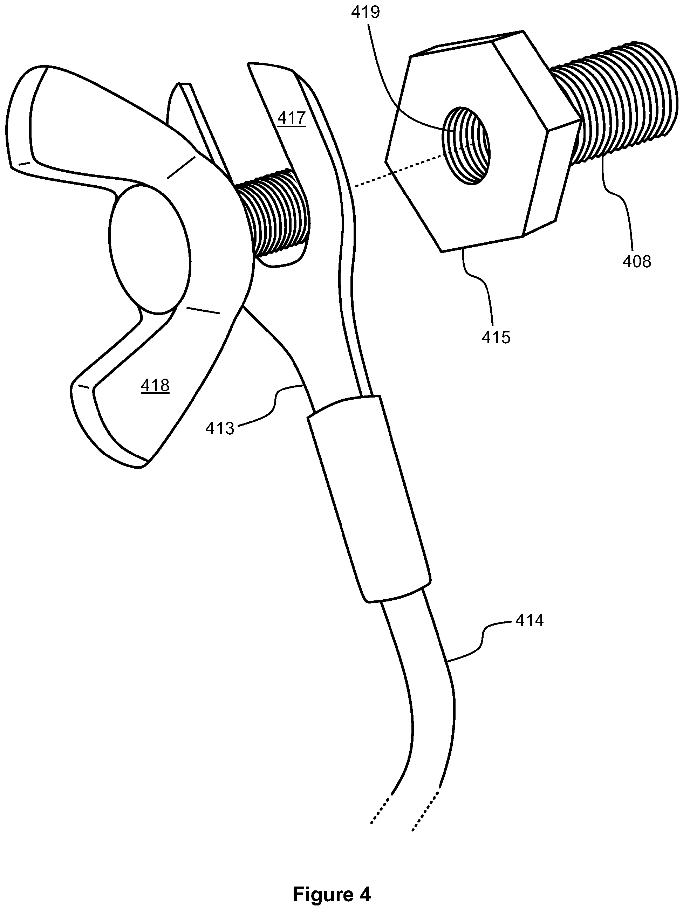

Figure 4 shows a mounting screw 408 and a connector terminal 413 according to an exemplifying and non-limiting embodiment of the invention. In this exemplifying case, the head 415 of the mounting screw comprises a threaded hole 419. The connector terminal 413 of the grounding cable 414 comprises a connector 417 that is attachable to the mounting screw 408 with a connector screw 418 suitable for the threaded hole 419. In the exemplifying case illustrated in figure 4, the connector screw 418 is a winged screw and the connector 417 is a slot connector. The slot connector 417 can be connected and disconnected without detaching the connector screw 418 from the mounting screw 408 but it suffices that the connector screw 418 is loosened in a sufficient extent.

The specific examples provided in the description given above should not be construed as limiting the applicability and/or the interpretation of the appended claims. Lists and groups of examples provided in the description given above are not exhaustive unless otherwise explicitly stated.

## Claims

1. Telecommunication equipment comprising:
- a rack (101) for carrying telecommunication devices, and
- at least one telecommunication device (104-107) attached to the rack with one or more mounting screws (108, 109),
**characterized in that** a head (115, 215, 315, 415) of at least one of the mounting screws of each telecommunication device is shaped to constitute a grounding connector for a connector terminal of a grounding cable so that the connector terminal is connectable to the grounding connector without changing a position of the one of the mounting screws with respect to the rack and to the telecommunication device attached to the rack with at least the one of the mounting screws.

2. Telecommunication equipment according to claim 1, wherein the head (115) of the mounting screw is shaped to be a male popper element having a recess suitable for a screwdriver.

3. Telecommunication equipment according to claim 1, wherein the head (215) of the mounting screw is a female popper element having an angulate outer periphery suitable for a wrench.

4. Telecommunication equipment according to claim 1, wherein the head (315) of the mounting screw comprises a threaded rod for allowing the connector terminal of the grounding cable to be attached with a nut.

5. Telecommunication equipment according to claim 1, wherein the head (415) of the mounting screw comprises a threaded hole for allowing the connector terminal of the grounding cable to be attached with a screw.

6. Telecommunication equipment according to any of claims 1-5, wherein the telecommunication equipment further comprises the grounding cable (114, 214, 314, 414), the connector terminal (113, 213, 313, 413) of the grounding cable being connectable to the grounding connector constituted by the head of the mounting screw.

7. Telecommunication equipment according to claim 6, wherein the head (115) of the mounting screw is shaped to be a male popper element having a recess suitable for a screwdriver, and the connector terminal (113) of the grounding cable comprises a female popper element.

8. Telecommunication equipment according to claim 6, wherein the head (215) of the mounting screw is a female popper element having an angulate outer periphery suitable for a wrench, and the connector terminal (213) of the grounding cable comprises a male popper element.

9. Telecommunication equipment according to claim 6, wherein the head (315) of the mounting screw comprises a threaded rod (318), and the connector terminal (313) of the grounding cable comprises a connector (317) attachable to the mounting screw with a nut suitable for the threaded rod.

10. Telecommunication equipment according to claim 6, wherein the head (415) of the mounting screw comprises a threaded hole (419), and the connector terminal (413) of the grounding cable comprises a connector (417) attachable to the mounting screw with a connector screw suitable for the threaded hole.

11. Telecommunication equipment according to any of claims 1-10, wherein the at least one telecommunication device (104) comprises a device-frame (110) attached to the rack with the one or more mounting screws and one or more plug-in units (111) installed in plug-in unit slots of the device-frame.

12. Telecommunication equipment according to any of claims 1-11, wherein the at least one telecommunication device comprises at least one of the following: an Internet Protocol "IP" router, an Ethernet switch, a MultiProtocol Label Switching "MPLS" switch, an Asynchronous Transfer Mode "ATM" switch, a packet optical switch.

## Patentansprüche

1. Telekommunikationseinrichtung, umfassend:
- ein Rack (101) zum Tragen von Telekommunikationsvorrichtungen und
- mindestens eine Telekommunikationsvorrichtung (104-107), die an dem Rack mit einer oder mehreren Montageschrauben (108, 109) angebracht ist,
**dadurch gekennzeichnet, dass** ein Kopf (115, 215, 315, 415) von mindestens einer der Montageschrauben jeder Telekommunikationsvorrichtung geformt ist, um einen Erdungsstecker für eine Anschlussklemme eines Erdungskabels zu bilden, so dass die Anschlussklemme mit dem Erdungsstecker ohne Ändern einer Position der einen der Montageschrauben in Bezug auf das Rack und mit der Telekommunikationsvorrichtung, die an dem Rack mit mindestens der einen der Montageschrauben angebracht ist, verbindbar ist.

2. Telekommunikationseinrichtung nach Anspruch 1, wobei der Kopf (115) der Montageschraube geformt ist, um ein männliches Druckknopfelement mit einer Vertiefung, die für einen Schraubendreher geeignet ist, zu sein.

3. Telekommunikationseinrichtung nach Anspruch 1, wobei der Kopf (215) der Montageschraube ein weibliches Druckknopfelement mit einem gewinkelten Außenumfang, die für einen Schraubenschlüssel geeignet ist, ist.

4. Telekommunikationseinrichtung nach Anspruch 1, wobei der Kopf (315) der Montageschraube eine mit einem Gewinde versehene Stange, um ein Anbringen der Anschlussklemme des Erdungskabels mit einer Mutter zu ermöglichen, umfasst.

5. Telekommunikationseinrichtung nach Anspruch 1, wobei der Kopf (415) der Montageschraube eine mit einem Gewinde versehene Bohrung, um ein Anbringen der Anschlussklemme des Erdungskabels mit einer Schraube zu ermöglichen, umfasst.

6. Telekommunikationseinrichtung nach einem der Ansprüche 1-5, wobei die Telekommunikationseinrichtung weiterhin das Erdungskabel (114, 214, 314, 414) umfasst, wobei die Anschlussklemme (113, 213, 313, 413) des Erdungskabels mit dem Erdungsstecker verbindbar ist, der von dem Kopf der Montageschraube gebildet wird.

7. Telekommunikationseinrichtung nach Anspruch 6, wobei der Kopf (115) der Montageschraube geformt ist, um ein männliches Druckknopfelement mit einer Vertiefung, die für einen Schraubendreher geeignet ist, zu sein, und die Anschlussklemme (113) des Erdungskabels ein weibliches Druckknopfelement umfasst.

8. Telekommunikationseinrichtung nach Anspruch 6, wobei der Kopf (215) der Montageschraube ein weibliches Druckknopfelement mit einem gewinkelten Außenumfang, die für einen Schraubenschlüssel geeignet ist, ist und die Anschlussklemme (213) des Erdungskabels ein männliches Druckknopfelement umfasst.

9. Telekommunikationseinrichtung nach Anspruch 6, wobei der Kopf (315) der Montageschraube eine mit einem Gewinde versehene Stange (318) umfasst und die Anschlussklemme (313) des Erdungskabels einen Stecker (317) umfasst, der an der Montageschraube mit einer Mutter, die für die mit dem Gewinde versehene Stange geeignet ist, anbringbar ist.

10. Telekommunikationseinrichtung nach Anspruch 6, wobei der Kopf (415) der Montageschraube eine mit einem Gewinde versehene Bohrung (419) umfasst und die Anschlussklemme (413) des Erdungskabels einen Stecker (417) umfasst, der an der Montageschraube mit einer Steckerschraube, die für die mit dem Gewinde versehene Bohrung geeignet ist, anbringbar ist.

11. Telekommunikationseinrichtung nach einem der Ansprüche 1-10, wobei die mindestens eine Telekommunikationseinrichtung (104) einen Geräterahmen (110), der an dem Rack mit der einen oder den mehreren Montageschrauben angebracht ist, und eine oder mehrere Einsteckeinheiten (111), die in Einsteckeinheitsschlitzen des Geräterahmens installiert sind, umfasst.

12. Telekommunikationseinrichtung nach einem der Ansprüche 1-11, wobei die mindestens eine Telekommunikationseinrichtung mindestens einen der folgenden umfasst: einen Internet-Protokoll-"IP"-Router, einen Ethernet-Switch, einen MultiProtocol-Label-Switching-"MPLS"-Switch, einen Asynchronous-Transfer-Mode-"ATM"-Switch, einen optischen Paket-Switch.

## Revendications

1. Equipement de télécommunications comprenant :
- une baie (101) pour supporter des dispositifs de télécommunications, et
- au moins un dispositif de télécommunications (104-107) fixé à la aie par une ou plusieurs vis de montage (108,109),
**caractérisé en ce que** une tête (115, 215, 315, 415) d'au moins une des vis de montage de chaque dispositif de télécommunication est façonnée afin de constituer un connecteur de mise à la terre pour une borne de connecteur d'un câble de mise à la terre de sorte que la borne de connecteur puisse être connectée au connecteur e mise à la terre sans changer une position d'une des vis de montage par rapport à la baie et au dispositif de télécommunication fixé à la baie par au moins une des vis de montage.

2. Equipement de télécommunications selon la revendication 1, dans lequel la tête (115) de la vis de montage est façonnée afin d'être un élément mâle faisant ressort ayant un évidement adéquat pour un tournevis.

3. Equipement de télécommunications selon la revendication 1, dans lequel la tête (215) de la vis de montage est un élément femelle faisant ressort ayant une périphérie extérieure angulaire adéquate pour une clé.

4. Equipement de télécommunications selon la revendication 1, dans lequel la tête (315) de la vis de montage comprend une tige filetée pour permettre de fixer la borne de connecteur du câble de mise à la terre avec un écrou.

5. Equipement de télécommunications selon la revendication 1, dans lequel la tête (415) de la vis de montage comprend un trou fileté pour permettre de fixer la borne de connecteur du câble de mise à la terre avec une vis.

6. Equipement de télécommunications selon une quelconque des revendications 1-5, dans lequel l'équipement de télécommunication comprend en outre le câble de mise à la terre (114, 214, 314, 414), la borne de terminal (113, 213, 313, 413) du câble de mise à la terre pouvant être connectée au connecteur de mise à la terre constitue par la tête de la vis de montage.

7. Equipement de télécommunications selon la revendication 6, dans lequel la tête (115) de la vis de montage est façonnée afin d'être un élément mâle faisant ressort ayant un évidement adéquat pour un tournevis, et la borne de connecteur (113) du câble de mise à la terre comprend un élément femelle faisant ressort.

8. Equipement de télécommunications selon la revendication 6, dans lequel la tête (215) de la vis de montage est un élément femelle faisant ressort ayant une périphérie extérieure angulaire adéquate pour une clé, et la borne de connecteur (213) du câble de mise à la terre comprend un élément mâle faisant ressort.

9. Equipement de télécommunications selon la revendication 6, dans lequel la tête (315) de la vis de montage comprend une tige filetée (318), et la borne de connecteur (313) du câble de mise à la terre comprend un connecteur (317) pouvant être fixé à la vis de montage avec un écrou adéquat pour la tige filetée.

10. Equipement de télécommunications selon la revendication 6, dans lequel la tête (415) de la vis de montage comprend un trou fileté (419), et la borne de connecteur (413) du câble de mise à la terre comprend un connecteur (417) pouvant être fixé à la vis de montage avec une vis de connecteur adéquate pour le trou fileté.

11. Equipement de télécommunications selon une quelconque des revendications 1-10, dans lequel au moins de télécommunication (104) comprend un cadre de dispositif (110) fixé à la baie avec la ou les vis de montage et une ou plusieurs unités enfichables (111) installées dans des fentes d'unités enfichables du cadre de dispositif.

12. Equipement de télécommunications selon une quelconque des revendications 1-11, dans lequel au moins un dispositif de télécommunication comprend au moins un des suivants : un routeur à protocole Internet « IP », un commutateur Ethernet, un commutateur à commutation par étiquette multiprotocoles « MPLS », un commutateur à mode de transfert asynchrone « ATM », un commutateur optique de paquets.
